Europäisches Patentamt

European Patent Office

Office européen des brevets

(19)

(11) EP 0 792 571 B1

(12) FASCICULE DE BREVET EUROPEEN

(45) Date de publication et mention
de la délivrance du brevet:
**15.12.1999 Bulletin 1999/50**

(21) Numéro de dépôt: 96931869.0

(22) Date de dépôt: 18.09.1996

(51) Int Cl.⁶: **H05H 1/00**, H01J 37/32

(86) Numéro de dépôt international:
**PCT/FR96/01451**

(87) Numéro de publication internationale:
**WO 97/11587 (27.03.1997 Gazette 1997/14)**

(54) **PROCEDE ET DISPOSITIF DE MESURE D'UN FLUX D'IONS DANS UN PLASMA**

VERFAHREN UND VORRICHTUNG ZUR MESSUNG EINES ZONENFLUSSES IN EINEM PLASMA

METHOD AND DEVICE FOR MEASURING ION FLOW IN A PLASMA

(84) Etats contractants désignés:
**CH DE FR GB IE IT LI**

(30) Priorité: **19.09.1995 FR 9511181**

(43) Date de publication de la demande:
**03.09.1997 Bulletin 1997/36**

(73) Titulaire: **CENTRE NATIONAL DE
LA RECHERCHE SCIENTIFIQUE (CNRS)
75700 Paris Cedex 07 (FR)**

(72) Inventeurs:
• **BOOTH, Jean-Paul
F-38610 Gières (FR)**
• **BRAITHWAITE, Nicholas, St John
F-38240 Meylan (FR)**

(74) Mandataire: **de Beaumont, Michel
1bis, rue Champollion
38000 Grenoble (FR)**

(56) Documents cités:
**EP-A- 0 145 015          US-A- 4 006 404**

• **MEASUREMENT SCIENCE AND TECHNOLOGY,
vol. 2, no. 8, 1 Août 1991, pages 795-800,
XP000259454 ANNARATONE B M ET AL: "A
COMPARISON OF A PASSIVE (FILTERED) AND
AN ACTIVE (DRIVEN) PROBE FOR RF PLASMA
DIAGNOSTICS"**
• **DATABASE WPI Section EI, Week 9315 Derwent
Publications Ltd., London, GB; Class S03, AN
93-125107 XP002003426 & SU,A,1 733 975
(LAVOCHKIN RES PRODN ASSOC), 15 Mai 1992**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

# Description

La présente invention concerne un procédé et un dispositif de mesure d'un flux d'ions positifs provenant d'un gaz ionisé, ou plasma, vers une surface solide avec laquelle il est en contact, par exemple, une paroi d'un réacteur à plasma ou un échantillon à traiter. L'invention s'applique plus particulièrement à la mesure du flux d'ions dans une enceinte constituant un réacteur à plasma destiné à revêtir un échantillon d'une couche mince, ou de modifier la structure ou la composition chimique d'une surface par bombardement ionique.

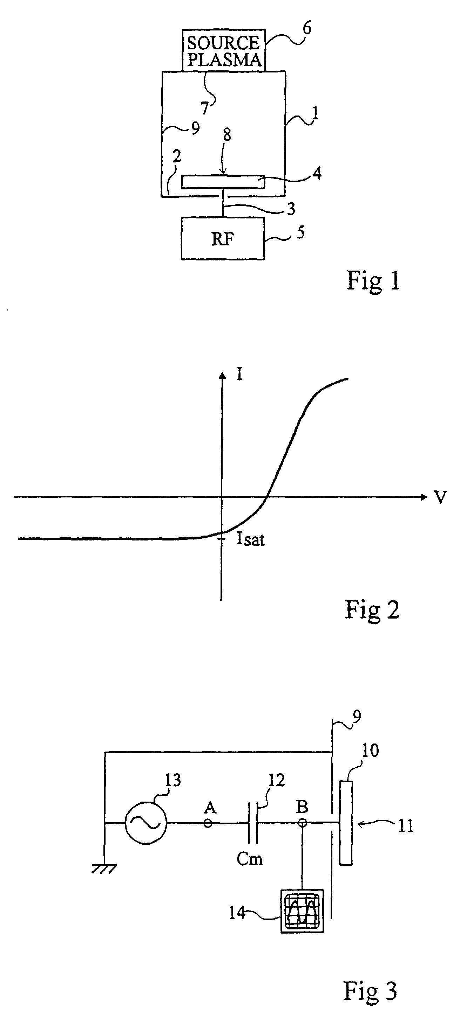

La figure 1 représente, schématiquement et en coupe, un exemple de réacteur à plasma auquel s'applique la présente invention. Il s'agit, par exemple, d'un réacteur dit à excitation radiofréquence par couplage capacitif.

Un tel réacteur est constitué d'une enceinte sous vide 1. Près d'une première paroi 2 de cette enceinte 1 est placé, sur un porte-substrat 3, un échantillon à traiter 4. L'échantillon 4 a généralement la forme d'un disque dont une surface 8 dirigée vers l'intérieur de l'enceinte 1 constitue la surface à traiter. L'enceinte 1 est remplie d'un gaz à faible pression, par exemple, de l'ordre de quelques dizaines à quelques centaines de millitorrs (quelques à quelques dizaines de pascals). Plusieurs moyens peuvent être utilisés pour générer le plasma. Par exemple, dans une configuration dite "gravure ionique réactive à couplage capacitif", une tension radiofréquence est appliquée au porte-substrat. On peut également, comme cela est représenté à la figure 1, générer le plasma au moyen d'une source 6 indépendante du porte-substrat 3. Cette source 6 est par exemple, une décharge à tension continue, une électrode indépendante du porte-substrat et alimentée par un générateur radiofréquence, une source radiofréquence à couplage inductif (souvent associée à une application d'un champ magnétique) ou une source micro-onde (éventuellement associée à une application d'un champ magnétique). Dans le cas de l'emploi d'une source 6 indépendante du porte-substrat 3, ce dernier peut être polarisé par une source radiofréquence 5 (figure 1) pour établir une autopolarisation et augmenter ainsi l'énergie d'impact des ions sur la surface à traiter.

Dans un processus de dépôt ou de gravure par plasma, il est important de connaître les caractéristiques de l'interaction entre la surface à traiter et le plasma pour pouvoir contrôler la mise en oeuvre du processus, en particulier, pour contrôler la vitesse de dépôt, ou de gravure, en fonction de l'épaisseur du dépôt, ou de la profondeur de la gravure, souhaitée. Le flux de particules chargées (ions et électrons) qui arrivent et qui quittent la surface à traiter permet de déterminer ces caractéristiques qui dépendent, notamment, du plasma utilisé.

Une méthode, dite à fluorescence induite, permet de déterminer, dans certains cas limités, la fonction de distribution en vitesse des ions. Cependant, une telle méthode ne permet pas de déterminer le flux d'ions de manière absolue. De plus, sa mise en oeuvre est particulièrement complexe et très onéreuse.

L'invention s'applique à une mesure électrique directe du flux d'ions dans un réacteur à plasma.

Diverses méthodes sont classiquement utilisées pour déterminer les caractéristiques des réacteurs à plasma à partir de mesures électriques.

Une première méthode, dite à "sonde de Langmuir", consiste à insérer, au milieu du plasma donc à l'écart des parois de l'enceinte, une petite électrode généralement de forme cylindrique. Cette électrode est reliée, à l'extérieur de l'enceinte, par un fil entouré d'une gaine isolante. Une tension variable $\underline{V}$ est appliquée entre la sonde et les parois du réacteur et on mesure le courant I dans le fil. La forme de la caractéristique courant-tension I(V) ainsi obtenue permet d'estimer des paramètres caractéristiques du plasma, comme la densité d'ions et d'électrons, la température des électrons et le potentiel du plasma. Par modélisation, ces paramètres permettent d'obtenir une estimation du flux d'ions vers les parois.

Une variante de cette méthode, dite à "sonde de Langmuir plane", consiste à placer, à proximité d'une paroi (par exemple 9, figure 1) de l'enceinte 1, une électrode en forme d'un disque de surface S assez importante (par exemple, quelques $cm^2$) dont la face arrière dirigée vers la paroi est revêtue d'un matériau isolant.

La figure 2 représente l'allure de la caractéristique courant-tension d'une telle électrode dans un réacteur à plasma. Lorsqu'on applique une tension $\underline{V}$ fortement négative, on arrive à un courant de saturation Isat. Ce courant Isat est une image du flux d'ions positifs $\Gamma_{ion}$ dans la mesure où tous les électrons sont repoussés. La relation qui lie le courant Isat au flux d'ions $\Gamma_{ion}$ en supposant que les ions sont ionisés une seule fois est donnée par la relation Isat = e.s.$\Gamma_{ion}$, où $\underline{e}$ représente la charge d'un électron.

Un inconvénient des méthodes à sonde de Langmuir, qui consistent à mesurer un courant continu entre la sonde et le plasma, est qu'elles ne fonctionnent plus si la sonde se trouve polluée, en particulier, si le plasma dépose une couche isolante sur l'électrode. C'est généralement le cas des gaz chimiquement complexes ($CF_4$, $SiH_4$, $CH_4$, etc.) qui déposent rapidement des couches minces isolantes sur toute surface en contact avec le plasma.

Une deuxième méthode consiste à échantillonner le flux d'ions (et d'électrons) au moyen d'un petit orifice (généralement d'environ 100 μm de diamètre) dans une électrode placée à proximité d'une paroi de l'enceinte. Un filtre électrostatique placé derrière l'orifice permet de séparer les ions positifs des électrons et ainsi de mesurer le courant d'ions transmis. Un inconvénient d'une telle méthode est qu'elle nécessite un calibrage du taux de transmission de l'orifice et du filtre électrostatique. Or, des dépôts de couches minces sur le filtre entraînent une modification de ce taux. Les mesures sont donc perturbées par ces dépôts dus au plasma ce qui les rend rapidement inexploitables et entraîne une défaillance complète de l'appareil de mesure.

Une conséquence des inconvénients des méthodes exposées ci-dessus est que les réacteurs à plasma classiques sont généralement caractérisés en fonctionnant avec un gaz rare, par exemple, de l'argon, préalablement à tout processus de dépôt ou de gravure. On ne peut donc pas connaître, autrement que par modélisation, les caractéristiques d'un réacteur en présence d'un gaz complexe.

Un autre inconvénient commun à toutes les méthodes connues est qu'elles ne permettent pas une mesure directe du flux d'ions pendant le traitement d'un échantillon. Elles ne permettent donc pas un asservissement d'un processus de dépôt ou de gravure.

La présente invention vise à pallier ces inconvénients en proposant un procédé de mesure d'un flux d'ions qui puisse être mis en oeuvre quel que soit le plasma utilisé. En particulier, l'invention vise à permettre la mesure du flux d'ions dans des plasmas déposant des couches minces isolantes.

L'invention vise également à proposer un procédé qui ne perturbe pas le processus de dépôt, ou de gravure, proprement dit. En particulier, l'invention vise à autoriser un asservissement d'un processus de dépôt, ou de gravure, par plasma.

L'invention vise également à proposer un dispositif pour la mise en oeuvre d'un tel procédé qui soit particulièrement simple à réaliser.

L'invention vise également à proposer un dispositif qui ne nécessite pas un étalonnage préalable aux mesures. En particulier, l'invention vise à permettre une mesure absolue du flux d'ions.

L'invention vise en outre à proposer un dispositif qui permette une mesure de l'homogénéité du flux d'ions au voisinage de la paroi de l'enceinte destinée à recevoir un échantillon à traiter.

Pour atteindre ces objets, la présente invention prévoit un procédé de mesure d'un flux d'ions provenant d'un plasma vers une surface en contact avec ce dernier, consistant à mesurer le taux de décharge d'un condensateur de mesure connecté entre une source de tension radiofréquence et une sonde en forme de plaque en contact avec le plasma.

Selon un mode de mise en oeuvre de la présente invention, le procédé de mesure consiste à alimenter la sonde, périodiquement, par des trains d'oscillations radiofréquence et à effectuer la mesure, entre deux trains d'oscillations, après l'amortissement du signal radiofréquence et avant que le potentiel de la sonde soit stabilisé.

Selon un mode de mise en oeuvre de la présente invention, le procédé de mesure consiste à effectuer une mesure de la variation du potentiel aux bornes du condensateur de mesure.

Selon un mode de mise en oeuvre de la présente invention, le procédé consiste à mesurer le courant de décharge du condensateur de mesure au moyen d'un transformateur interposé entre ce condensateur et la sonde.

Selon un mode de mise en oeuvre de la présente invention, la valeur du condensateur de mesure est inférieure à la valeur de la capacité d'une couche mince éventuellement attendue sur la sonde.

L'invention concerne également un dispositif de mesure d'un flux d'ions dans une enceinte sous vide constituant un réacteur à plasma, comportant :

une sonde interne à l'enceinte et comportant une surface sensible plane ;
des moyens externes à l'enceinte pour alimenter, périodiquement, la sonde par une tension radiofréquence ;
un condensateur de mesure externe à l'enceinte monté en série entre lesdits moyens d'alimentation et ladite sonde ; et
des moyens externes à l'enceinte pour mesurer, périodiquement, le courant de décharge du condensateur de mesure ou les variations de potentiel aux bornes de ce condensateur pendant sa décharge.

Selon un mode de réalisation de la présente invention, ladite sonde est constituée d'un disque relié, par un conducteur sensiblement axial, à une borne dudit condensateur de mesure, les faces arrière et latérale du disque étant entourées d'un isolant et d'une gaine conductrice ayant une fonction d'écran et d'anneau de garde.

Selon un mode de réalisation de la présente invention, ladite gaine est reliée à ladite source d'alimentation par l'intermédiaire d'un condensateur.

Selon un mode de réalisation de la présente invention, lesdits moyens d'alimentation sont constitués par une source de tension radiofréquence qui fournit des trains d'oscillations radiofréquence, ladite mesure s'effectuant entre deux trains d'oscillations.

Selon un mode de réalisation de la présente invention, la période des oscillations radiofréquence est courte par rapport à la durée d'application de ces oscillations, la durée d'application des trains d'oscillations étant suffisamment longue pour établir une tension d'autopolarisation de la sonde et l'intervalle de temps entre deux trains d'oscillations étant suffisamment long pour permettre la mesure.

Ces objets, caractéristiques et avantages, ainsi que d'autres de la présente invention seront exposés en détail dans la description suivante de modes de mise en oeuvre et de réalisation particuliers faite à titre non-limitatif en relation avec les figures jointes parmi lesquelles :

les figures 1 et 2 qui ont été décrites précédemment sont destinées à exposer l'état de la technique et le problème posé ;
la figure 3 représente, schématiquement, un mode de réalisation d'un dispositif de mesure d'un flux d'ions selon l'invention ;

la figure 4 est une vue en coupe d'un mode de réalisation d'une sonde d'un dispositif de mesure selon l'invention tel que représenté à la figure 3 ; et

les figures 5 et 6 illustrent un mode de mise en oeuvre du procédé de mesure d'un flux d'ions selon l'invention.

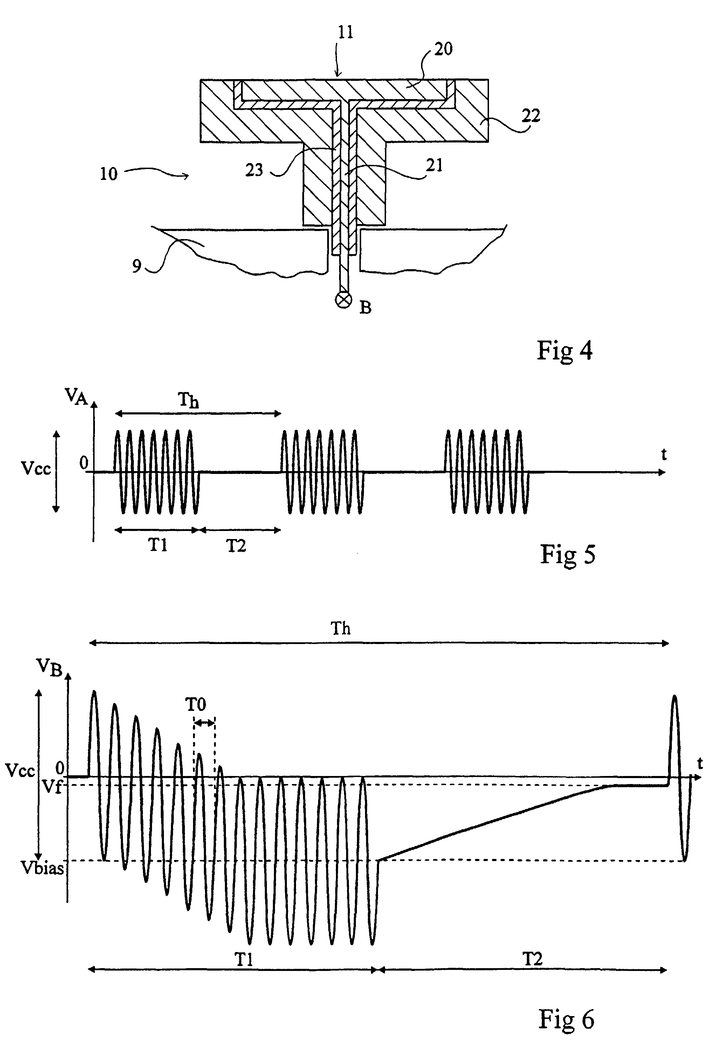

Pour des raisons de clarté, seuls les éléments du dispositif selon l'invention et du réacteur à plasma qui sont nécessaires à la compréhension de l'invention ont été représentés. De même, les chronogrammes des figures 5 et 6 ne sont pas à l'échelle et les mêmes éléments ont été désignés par les mêmes références aux différentes figures.

La figure 3 représente, schématiquement, un mode de réalisation d'un dispositif de mesure d'un flux d'ions selon l'invention.

Ce dispositif est constitué d'une sonde 10 destinée à être placée à proximité d'une surface vers laquelle on souhaite déterminer le flux d'ions, par exemple, la paroi 9 (figure 1), d'une enceinte sous vide (non représentée) d'un réacteur à plasma. Une surface sensible 11 de la sonde 10 est dirigée vers l'intérieur de l'enceinte. Selon l'invention, la sonde 10 est reliée à un condensateur de mesure 12 de capacité $C_m$. Une première borne $\underline{A}$ du condensateur 12 est reliée à une première borne d'une source de tension radiofréquence 13 de faible impédance de sortie (typiquement 50 ohms) dont une deuxième borne est reliée aux parois du réacteur et, avec celles-ci, à un potentiel de référence, généralement la masse. Dans le cas où les parois du réacteur sont en un matériau non-conducteur, une électrode de surface supérieure à celle de la sonde est ajoutée pour servir de référence aux mesures. Une seconde borne $\underline{B}$ du condensateur 12 constitue, à la fois, une borne d'entrée du dispositif destinée à être raccordée à la sonde 10 et une borne de sortie du dispositif vers des moyens de mesure, par exemple, un oscilloscope 14.

La figure 4 est une vue en coupe d'un exemple de réalisation de la sonde 10 équipant un dispositif de mesure selon l'invention tel que représenté à la figure 3.

La sonde 10 est constituée d'un disque plan 20 destiné à être relié, par un conducteur 21, à la borne $\underline{B}$ du dispositif de mesure. Le conducteur 21 traverse donc la paroi (par exemple, 9) à proximité de laquelle est placée la sonde 10. La face du disque 20 dirigée vers l'intérieur de l'enceinte constitue la surface sensible 11 de la sonde. La sonde est, de préférence, entourée d'un anneau de garde. Cet anneau de garde, destiné à éviter l'influence des effets de bord, est par exemple constitué d'un disque conducteur 22 concentrique, plus grand et plus épais que le disque 20. Le disque 22 est muni d'un évidement dans lequel est inséré le disque 20. Les faces latérales et la face arrière du disque 20 ainsi que le conducteur 21 sont isolés du disque 22 par un isolant 23. Pour que le disque 22 assure au mieux son rôle d'anneau de garde, il est de préférence relié électriquement d'une façon non représentée à la borne $\underline{A}$ par un condensateur de valeur $C_g$ (non représenté). Pour que le potentiel de l'anneau de garde soit toujours proche du potentiel de la sonde, on choisira $C_g$ tel que :

$C_g/C_m = S_g/S_m$, où $S_g$ et $S_m$ représentent, respectivement, les surfaces de l'anneau de garde et de la sonde.

Selon l'invention, la sonde 10 est excitée par la source de tension radiofréquence 13 de manière périodique. En d'autres termes, la source 13 fournit des trains d'oscillations à intervalles réguliers entre lesquels on observe la décharge du condensateur de mesure 12.

La figure 5 illustre la forme du signal appliqué à la borne $\underline{A}$ du condensateur 12 par la source 13. Cette figure représente, sous forme de chronogramme, le potentiel $V_A$ de la borne $\underline{A}$. La périodicité $T_h$ des trains d'oscillations correspond, par exemple, à une fréquence fh $= 1/T_h$ comprise entre 1 et 20 kHz. Les oscillations radiofréquence durent pendant une période $T_1$ correspondant, par exemple, à environ la moitié $(T_h/2)$ de la période des trains d'oscillations. Les mesures sont effectuées à l'intérieur de l'intervalle de temps $T_2$ entre deux trains d'oscillations de durée $T_1$. Un signal tel que représenté à la figure 5 est, par exemple, obtenu au moyen d'une source 13 dont la sortie est hachée à une fréquence $f_h$.

La fréquence $f_o$ des oscillations radiofréquence est, par exemple, comprise entre 1 et 20 MHz. Pour un réacteur à plasma à excitation radiofréquence, on veillera à ce que la valeur de la fréquence $f_o$ soit suffisamment éloignée de la fréquence d'excitation du plasma (par la source 6 de la figure 1) pour éviter l'apparition d'interférences avec le potentiel du plasma. A titre d'exemple particulier, pour un plasma généré au moyen d'un générateur d'une fréquence d'environ 13,5 MHz à couplage capacitif, on évitera de choisir, pour la fréquence $f_o$, une fréquence comprise entre 12 et 15 MHz.

Sous l'effet des oscillations délivrées par la source 13 et de la non-linéarité du courant (en fonction de la tension appliquée) fourni à la sonde par le plasma, le flux moyen d'électrons vers la sonde dépasse, initialement, le flux moyen d'ions positifs, ce qui provoque la charge du condensateur 12. La valeur moyenne des oscillations du potentiel de la borne $\underline{B}$ va diminuer jusqu'à atteindre une valeur négative correspondant à un potentiel $V_{bias}$ où le flux d'électrons est diminué jusqu'à atteindre une valeur identique au flux d'ions, donc où le courant moyen résultant dans la sonde 10 est nul. Ce potentiel $V_{bias}$ résulte de l'effet classique d'autopolarisation existant dans un plasma.

La figure 6 illustre ce fonctionnement et représente, sous forme de chronogramme, le potentiel de la borne $\underline{B}$ du condensateur 12, en présence de plasma. Le potentiel $V_{bias}$ d'autopolarisation correspond, sensiblement, à la moitié de l'amplitude crête à crête $V_{cc}$ des oscillations radiofréquence.

A la fin du train d'oscillations, c'est-à-dire lorsque le signal radiofréquence est coupé, la borne $\underline{B}$ du condensateur 12 se retrouve, après l'amortissement des oscillations, au potentiel d'autopolarisation $V_{bias}$. La sonde 10 étant alors polarisée à un potentiel fortement négatif, elle n'est plus en mesure de capter des électrons. Par contre, le flux d'ions arrivant sur la surface 11 de la sonde 10 reste inchangé et commence à décharger le condensateur 12. Ainsi, le potentiel de la borne $\underline{B}$ du condensateur 12 va croître de manière linéaire jusqu'à converger vers un potentiel flottant qui correspond à une valeur $V_f$ où le flux d'ions et le flux d'électrons se compensent.

Selon l'invention, on mesure le taux de décharge du condensateur 12 pendant la période linéaire où le courant est composé uniquement du flux d'ions (flux d'électrons nul). Ces mesures sont effectuées, soit en observant la dérivée temporelle $dV_B/dt$ du potentiel à la borne $\underline{B}$, soit en observant le courant $I_B$ circulant vers le condensateur 12 à l'aide d'un transformateur interposé entre la sonde 10 et le condensateur 12. On utilise pour cela, par exemple, un oscilloscope 14 ou un circuit spécifique de traitement du signal. Les mesures sont effectuées après l'amortissement des oscillations radiofréquence et avant que la variation du signal ne soit plus linéaire, c'est-à-dire avant que le potentiel de la borne $\underline{B}$ s'approche du potentiel flottant $V_f$.

Pendant la décharge du condensateur 12, la variation du potentiel de la borne $\underline{B}$ suit, en première approximation, la relation :

$$dV_B/dt = e.\, S_m.(\Gamma_{ion} - \Gamma_e)/C_m,$$

où $\Gamma_{ion}$ et $\Gamma_e$ représentent, respectivement, le flux d'ions et le flux d'électrons et où $\underline{e}$ représente la charge d'un électron.

Le flux d'électrons $\Gamma_e$ varie en fonction du potentiel VB et devient nul lorsque le potentiel $V_B$ est fortement négatif, comme dans le cas d'une sonde de Langmuir plane.

L'amplitude du signal radiofréquence est choisie suffisamment grande (par exemple, de l'ordre de plusieurs dizaines de volts) pour que le potentiel d'autopolarisation $V_{bias}$ soit suffisamment négatif pour empêcher que les électrons soient captés par la sonde 10 pendant un temps suffisant pour effectuer la mesure. Cela revient à dire que l'amplitude $V_{cc}$ du signal radiofréquence est choisie pour être nettement supérieure à la température électronique exprimée en électronvolts.

Ainsi, tant que les électrons sont repoussés par la sonde dans la mesure où elle est à un potentiel suffisamment négatif par rapport au potentiel $V_f$, le flux d'électrons $\Gamma_e$ sur la sonde est nul et la pente de décharge du condensateur 12 est proportionnelle au flux d'ions $\Gamma_{ion}$.

En mesurant cette pente, par exemple, au moyen de l'oscilloscope 14, on peut déduire le flux d'ions de la relation :

$$I_B = C_m.dV_B/dt = e.\, S_m.\Gamma_{ion}.$$

La présence d'un plasma déposant une couche mince isolante n'affecte pas le fonctionnement d'un dispositif selon l'invention. Cette couche mince se traduit, du point de vue électrique, par une capacité $C_i$ (non représentée) en série avec le condensateur 12 entre la borne $\underline{B}$ et le plasma. La conséquence de la présence de cette capacité est que le potentiel mesuré sur la borne $\underline{B}$ ne correspond pas au potentiel d'autopolarisation $V_{bias}$ mais à une fraction de ce potentiel en raison de l'association série du condensateur 12 avec la capacité $C_i$ de la couche isolante.

La relation qui lie le potentiel de la borne $\underline{B}$ au potentiel $V_s$ de la surface de la sonde en contact avec le plasma, à l'instant où le signal radiofréquence est coupé, est :

$$V_B = V_s.C_i/(C_m + C_i).$$

La valeur du potentiel $V_s$ à l'instant où le signal radiofréquence est coupé est toujours $V_{bias}$. La valeur absolue initiale du potentiel $V_B$ sera donc réduite. Cependant, tant que le potentiel $V_s$ reste suffisamment négatif, le flux d'ions et donc le courant (identique) circulant à travers les capacités $C_m$ et $C_i$ reste inchangé. Les effets de la capacité Ci de la couche isolante sont de réduire la valeur absolue du potentiel $V_B$ obtenue à la fin des oscillations radiofréquence, de réduire la charge accumulée par le condensateur 12 de capacité $C_m$ et de réduire le temps de décharge du condensateur 12 et, par conséquent, la période linéaire pendant laquelle les mesures peuvent être effectuées. Par contre, la valeur initiale de la dérivée temporelle $dV_B/dt$ reste inchangée et la vitesse de décharge est toujours, au début, proportionnelle au flux d'ions $\Gamma_{ion}$ pour une amplitude $V_{cc}$ du signal radiofréquence suffisamment élevée.

De préférence, la capacité $C_m$ du condensateur 12 est choisie pour être inférieure à la capacité attendue de la couche mince isolante susceptible d'être déposée sur la sonde 10 par le plasma. Cela présente l'avantage d'augmenter la durée pendant laquelle la variation de potentiel sur la borne $\underline{B}$ est exploitable.

Le choix de la valeur du condensateur 12 dépend du niveau de bruit électrique de l'installation à laquelle est associé le dispositif et de la durée de décharge exploitable souhaitée. En effet, plus la capacité $C_m$ est grande, plus la décharge du condensateur de mesure 12 est lente.

Si la valeur du condensateur 12 est trop importante, la variation de potentiel mesurée $dV_B/dt$ est trop lente et les mesures risquent d'être faussées par du bruit.

Si la valeur du condensateur 12 est trop faible, sa décharge risque d'être trop rapide et de ne pas laisser un temps suffisant pour atteindre un équilibre de la région de charge d'espace devant la sonde, entraînant ainsi une erreur dans la mesure. Le temps nécessaire à cet équilibre est donné par la période ion-plasma :

$$t_{ion} = (M_i.\varepsilon_0/n.e^2)^{\frac{1}{2}},$$ où $M_i$ représente la masse de l'ion, où $\varepsilon_0$ représente la permittivité de l'espace et où $\underline{n}$ représente la densité des ions dans le plasma.

La valeur du condensateur 12 est, par exemple, choisie d'environ quelques nanofarads. Une telle valeur respecte la condition par rapport à la capacité d'une éventuelle couche mince isolante déposée par le plasma. En effet, la capacité d'une couche mince isolante avec une constante diélectrique relative $\varepsilon_r$ de 4 et d'une épaisseur de 0,1 µm est de l'ordre de 177 nanofarads pour une sonde de 5 cm$^2$.

On veillera à ce que la période $T_o = 1/f_o$ des oscillations radiofréquence soit courte par rapport à la durée $T_1$ d'application de ces oscillations, à ce que la durée $T_1$ soit suffisamment longue pour permettre une autopolarisation de la sonde au potentiel $V_{bias}$ et à ce que l'intervalle de temps $T_2$ entre deux trains d'oscillations soit suffisamment long pour permettre la mesure du taux de décharge du condensateur 12.

Un avantage de la présente invention est qu'elle est applicable à n'importe quelle composition chimique de plasma. Seule une attaque chimique (gravure) très importante du ou des matériaux dont la sonde est constituée ou un dépôt d'une couche isolante dont l'épaisseur est telle qu'elle ne permet plus d'atteindre une autopolarisation de la sonde constitue une limite au fonctionnement du dispositif de mesure.

Un autre avantage de l'invention est que les résultats obtenus sont indépendants de la nature chimique des ions récoltés par la sonde. En effet, on ne mesure que le courant électrique, donc le flux total des ions positifs.

Un autre avantage de la présente invention est qu'elle autorise un asservissement d'un processus de dépôt ou de gravure pendant sa mise en oeuvre. Une sonde selon l'invention peut être placée à proximité d'une paroi de l'enceinte autre que celle à proximité de laquelle est placé un échantillon à traiter. Le résultat de la mesure opérée par le dispositif selon l'invention peut alors être utilisé pour asservir le processus. Si le dispositif détecte une légère variation du flux d'ions (accélération ou ralentissement de la vitesse de décharge du condensateur de mesure), il peut délivrer une consigne permettant de modifier le signal radiofréquence ou micro-onde d'excitation du gaz afin de modifier le plasma. Si le dispositif détecte une chute brutale du flux d'ions, il peut générer une alarme indiquant que les parois de l'enceinte sont polluées. On notera que plusieurs sondes associées à plusieurs dispositifs de mesures peuvent être réparties à proximité des parois de l'enceinte pour disposer de mesures dans différentes régions de l'enceinte.

Un autre avantage de la présente invention est qu'elle permet de vérifier, dans une phase de caractérisation de l'enceinte, l'homogénéité du flux d'ions dans la région de l'enceinte destinée à recevoir un échantillon à traiter et ce, avec n'importe quel plasma. Pour ce faire, plusieurs sondes et dispositifs de mesures selon l'invention sont répartis à proximité de la paroi destinée à recevoir, en fonctionnement normal, l'échantillon à traiter. L'interprétation des mesures données par les différents dispositifs de mesure permet de dresser une carte de la répartition du flux d'ions à proximité de la paroi concernée.

Selon l'invention, la surface sensible 11 de la sonde 10 est relativement importante (de l'ordre de plusieurs centimètres carrés). En effet, plus la surface de la sonde est importante, plus le courant récolté est important pour un flux d'ions donné. Cela permet d'améliorer le rapport signal/bruit et la résolution temporelle de la sonde. De plus, les effets de bord et les effets de couches isolantes éventuelles déposées sur la sonde sont minimisés avec une sonde de taille importante. Dans une application où plusieurs sondes sont utilisées pour établir une cartographie du flux d'ions en fonction de la position, on adaptera (en la limitant) la taille des sondes pour obtenir une résolution spatiale adéquate.

Un autre avantage de la présente invention est que les mesures ne sont pas affectées par des champs magnétiques tant que le rayon gyromagnétique de l'ion est inférieur à la taille de la sonde et que l'amplitude et l'orientation du champ magnétique n'empêchent pas les électrons d'arriver jusqu'à la sonde, donc de charger le condensateur 12 pour établir une autopolarisation. La taille de la sonde 10 peut ainsi être adaptée au champ magnétique maximal attendu. Par exemple, pour une sonde dont le disque présente un diamètre de 1 cm, les mesures ne seront pas perturbées par des champs magnétiques inférieurs à 0,1 T (1000 Gauss).

Selon une variante de l'invention, le porte-substrat 3 (figure 1) peut servir de sonde de flux d'ions. Dans ce cas, l'alimentation radiofréquence (générateur 5, figure 1) qui sert à établir l'autopolarisation du substrat et qui, dans le cas d'une gravure ionique réactive à couplage capacitif, entretient le plasma est hachée et joue alors le rôle de source de tension radiofréquence 13 selon l'invention. Des moyens similaires à ceux exposés en relation avec la figure 3 sont utilisés pour mesurer le flux d'ions. Bien que la mise en oeuvre d'une telle variante risque, le cas échéant, de perturber le traitement du substrat, elle permet d'étudier la différence éventuelle, entre les flux sur les parois et sur le porte-substrat, qui peut être due à une répartition non-homogène des régions de production des ions.

On notera également que l'invention permet également de déterminer le potentiel du plasma et la température électronique. En effet, en analysant la caractéristique courant-tension de la borne $\underline{B}$ lorsque le potentiel $V_B$ s'approche du potentiel flottant $V_f$, la sonde peut alors fournir des paramètres caractéristiques du plasma à la manière d'une sonde de Langmuir classique.

Bien entendu, la présente invention est susceptible de diverses variantes et modifications qui apparaîtront à l'homme de l'art. En particulier, les matériaux, dimensions, capacités et fréquences indiqués à titre d'exemple pourront être modifiés, notamment, en fonction du réacteur à plasma auquel est destiné le dispositif. De plus, bien que l'on ait fait référence dans la description qui précède à un réacteur générant le plasma au moyen d'un générateur radiofréquence à couplage capacitif, l'invention s'applique quel que soit le mode d'excitation du gaz, qu'il soit continu, radiofréquence ou micro-onde. En outre, l'invention s'applique également à une mesure de flux d'espèces chargées présents dans des plasmas autres que des ions positifs, telles que des agrégats de tailles nanométriques ou des particules de poussière avec une charge positive.

## Revendications

1. Procédé de mesure d'un flux d'ions provenant d'un plasma vers une surface en contact avec ce dernier, caractérisé en ce qu'il consiste à mesurer le taux de décharge d'un condensateur de mesure (12) connecté entre une source de tension radiofréquence (13) et une sonde (10) en forme de plaque en contact avec le plasma.

2. Procédé de mesure selon la revendication 1, caractérisé en ce qu'il consiste à alimenter la sonde (10), périodiquement, par des trains d'oscillations radiofréquence et à effectuer la mesure, entre deux trains d'oscillations, après l'amortissement du signal radiofréquence et avant que le potentiel de la sonde (10) soit stabilisé.

3. Procédé de mesure selon la revendication 1 ou 2, caractérisé en ce qu'il consiste à effectuer une mesure de la variation du potentiel aux bornes du condensateur de mesure (12).

4. Procédé de mesure la revendication 1 ou 2, caractérisé en ce qu'il consiste à mesurer le courant de décharge du condensateur de mesure (12) au moyen d'un transformateur interposé entre ce condensateur (12) et la sonde (10).

5. Procédé de mesure selon l'une quelconque des revendications 1 à 4, caractérisé en ce que la valeur du condensateur de mesure (12) est inférieure à la valeur de la capacité d'une couche mince éventuellement attendue sur la sonde (10).

6. Dispositif de mesure d'un flux d'ions dans une enceinte sous vide (1) constituant un réacteur à plasma, caractérisé en ce qu'il comporte :

une sonde (10) interne à l'enceinte (1) et comportant une surface sensible (11) plane ;

des moyens (13) externes à l'enceinte (1) pour alimenter, périodiquement, la sonde (10) par une tension radiofréquence ;
un condensateur de mesure (12) externe à l'enceinte (1) monté en série entre lesdits moyens d'alimentation (13) et ladite sonde (10) ; et
des moyens (14) externes à l'enceinte (1) pour mesurer, périodiquement, le courant de décharge du condensateur de mesure (12) ou les variations de potentiel aux bornes de ce condensateur (12) pendant sa décharge.

7. Dispositif de mesure selon la revendication 6, caractérisé en ce que ladite sonde (10) est constituée d'un disque (20) relié, par un conducteur (21) sensiblement axial, à une borne (B) dudit condensateur de mesure (12), les faces arrière et latérale du disque (20) étant entourées d'un isolant (23) et d'une gaine conductrice (22) ayant une fonction d'écran et d'anneau de garde.

8. Dispositif de mesure selon la revendication 7, caractérisé en ce que ladite gaine (22) est reliée à ladite source d'alimentation par l'intermédiaire d'un condensateur.

9. Dispositif de mesure selon l'une quelconque des revendications 6 à 8, caractérisé en ce que lesdits moyens d'alimentation sont constitués par une source de tension radiofréquence (13) qui fournit des trains d'oscillations radiofréquence, ladite mesure s'effectuant entre deux trains d'oscillations.

10. Dispositif de mesure selon la revendication 9, caractérisé en ce que la période $(T_o)$ des oscillations radiofréquence est courte par rapport à la durée $(T_1)$ d'application de ces oscillations, la durée d'application des trains d'oscillations $(T_1)$ étant suffisamment longue pour établir une tension d'autopolarisation $(V_{bias})$ de la sonde (10) et l'intervalle de temps $(T_2)$ entre deux trains d'oscillations étant suffisamment long pour permettre la mesure.

## Patentansprüche

1. Verfahren zur Messung eines Ionenflusses aus einem Plasma zu einer mit diesem in Kontakt stehenden Oberfläche, **dadurch gekennzeichnet** daß das Verfahren in der Messung der Entladungsrate eines Meßkondensators (12) besteht, der zwischen einer Hf-Spannungsquelle (13) und einer Sonde (10) in Form einer mit dem Plasma in Kontakt stehenden Platte geschaltet ist.

2. Meßverfahren nach Anspruch 1, dadurch gekennzeichnet, daß man die Sonde (10) periodisch mit Hf-Schwingungszügen beaufschlagt und die Messung zwischen zwei Schwingungszügen nach dem Abklingen des Hf-Signals und vor der Stabilisierung des Potentials der Sonde (10) vornimmt.

3. Meßverfahren nach Anspruch 1 oder 2, dadurch gekennzeichnet, daß man eine Messung der Änderung des Potentials an den Anschlüssen des Meßkondensators (12) vornimmt.

4. Meßverfahren nach Anspruch 1 oder 2, dadurch gekennzeichnet, daß man den Entladestrom des Meßkondensators (12) mit Hilfe eines zwischen diesem Kondensator (12) und der Sonde (10) angeordneten Transformators mißt.

5. Meßverfahren nach einem der Ansprüche 1 bis 4, dadurch gekennzeichnet, daß die Kapazität des Meßkondensators (12) kleiner als die Kapazität einer gegebenenfalls erwarteten dünnen Schicht auf der Sonde (10) ist.

6. Vorrichtung zur Messung eines Ionenflusses in einem einen Plasma-Reaktor bildenden Vakuumbehälter, dadurch gekennzeichnet, daß die Vorrichtung umfaßt:

eine Sonde (10) im Inneren des Behälters (1) mit einer ebenen Meßfläche (11);

außerhalb des Behälters (1) angeordnete Mittel (13) zur periodischen Beaufschlagung mit einer Hf-Spannung;

einen außerhalb des Behälters (1) in Reihenschaltung mit den genannten Beaufschlagungsmitteln (13) und der genannten Sonde (10) angeordneten Meßkondensator; sowie

außerhalb des Behälters (1) angeordnete Mittel (14) zur periodischen Messung des Entladestroms des Meßkondensators (12) oder der Potentialänderungen an den Anschlüssen des Kondensators (12) während seiner Entladung.

7. Meßvorrichtung nach Anspruch 6, dadurch gekennzeichnet, daß die genannte Sonde (10) aus einer Scheibe (20) besteht, die über einen im wesentlichen axialen Leiter (21) mit einem Anschluß (B) des genannten Meßkondensators (12) verbunden ist, und daß die Rückseite und Seitenflächen der Scheibe (20) von einer Isolation (23) und einer leitenden Hülse (22) umschlossen sind, welche die Funktion einer Abschirmung und eines Schutzrings hat.

8. Meßvorrichtung nach Anspruch 7, dadurch gekennzeichnet, daß die genannte Hülse (22) mit der genannten Beaufschlagungs- bzw. Speisequelle über einen Kondensator verbunden ist.

9. Meßvorrichtung nach einem der Ansprüche 6 bis 8, dadurch gekennzeichnet, daß die genannten Beaufschlagungs- bzw. Speisemittel aus einer Hf-Spannungsquelle (13) bestehen, welche Hf-Schwingungszüge liefert, wobei die Messung zwischen zwei Schwingungszügen erfolgt.

10. Meßvorrichtung nach Anspruch 9, dadurch gekennzeichnet, daß die Periode ($T_o$) der Hf-Schwingungen kurz bezogen auf die Beaufschlagungsdauer ($T_1$) dieser Schwingungen ist, und daß die Beaufschlagungsdauer ($T_1$) der Schwingungszüge hinreichend lang zur Ausbildung einer automatischen SelbstVorspannung ($V_{bias}$) der Sonde (10) und daß das Zeitintervall ($T_2$) zwischen zwei Schwingungszügen hinreichend lang zur Ermöglichung der Messung ist.

**Claims**

1. A method for measuring an ion flow from a plasma to a surface in contact therewith, characterized in that it consists of measuring the discharge rate of a measuring capacitor (12) connected between a radiofrequency voltage source (13) and a plate-shaped probe (10) in contact with the plasma.

2. A measurement method according to claim 1, characterized in that it consists of periodically supplying the probe (10) with radiofrequency oscillation trains and performing the measurement, between two oscillation trains, after the damping of the radiofrequency signal and before the potential of the probe (10) is stabilized.

3. A measurement method according to claim 1 or 2, characterized in that it consists of performing a measurement of the potential variation across the measuring capacitor (12).

4. A measurement method according to claim 1 or 2, characterized in that it consists of measuring the discharge current of the measuring capacitor (12) by means of a transformer interposed between the capacitor (12) and the probe (10).

5. A measurement method according to any of claims 1 to 4, characterized in that the value of the measuring capacitance (12) is lower than the value of the capacitance of a thin layer which may be expected on the probe (10).

6. A device for measuring an ion flow in a vacuum enclosure (1) constituting a plasma reactor, characterized in that it includes:

a probe (10) internal to the enclosure (1) and having a planar sensitive surface (11); means (13) external to the enclosure (1) for periodically supplying the probe (10) with a radiofrequency voltage; a measuring capacitor (12) external to the enclosure (1) mounted in series between the supplying means (13) and the probe (10); and means (14) external to the enclosure (1) for periodically measuring the discharge current of the measuring capacitor (12) or the potential variations across the capacitor (12) during its discharge.

7. A measurement device according to claim 6, characterized in that the probe (10) is comprised of a disk (20) connected, by a substantially axial conductor (21), to a terminal (B) of the measuring capacitor (12), the rear and lateral surfaces of the disk (20) being surrounded with an insulator (23) and a conductive sheath (22) acting as a screen and a guard ring.

8. A measurement device according to claim 7, characterized in that the sheath (22) is connected to the supply source via a capacitor.

9. A measurement device according to any of claims 6 to 8, characterized in that the supplying means are comprised of a radiofrequency voltage source (13) which provides radiofrequency oscillation trains, the measurement being performed between two oscillation trains.

10. A measurement device according to claim 9, characterized in that the period ($T_o$) of the radiofrequency oscillations is short with respect to the application time ($T_1$) of these oscillations, the application time of the oscillation trains ($T_1$) being long enough to establish a self-biasing voltage ($V_{bias}$) for the probe (10) and the time interval ($T_2$) between two oscillation trains being long enough to enable the measurement.

SOURCE PLASMA 6

7

9

8

2

4

3

RF 5

1

**Fig 1**

I

Isat

V

**Fig 2**

9

10

13

A

12

B

Cm

11

14

**Fig 3**

Fig 4

Fig 5

Fig 6